# EUROPEAN PATENT APPLICATION

(11) **EP 3 748 744 A1**
(43) Date of publication of application: **09.12.2020**
(21) Application number: 18907452.9
(22) Date of filing: 22.08.2018
(51) Int. Cl.: H01M 4/583

(54) **COMPOSITE MATERIAL AND PREPARATION METHOD THEREFOR**

(30) Priority: 26.02.2018 CN 201810159491
(71) Applicant: HUAWEI TECHNOLOGIES CO., LTD., Shenzhen, Guangdong 518129 (CN)
(72) Inventor: SU, Hang, Shenzhen, Guangdong 518129 (CN); LI, Yangxing, Shenzhen, Guangdong 518129 (CN); YU, Zhexun, Shenzhen, Guangdong 518129 (CN); WANG, Pinghua, Shenzhen, Guangdong 518129 (CN)
(74) Representative: Maiwald Patent- und Rechtsanwaltsgesellschaft mbH
(86) International application number: PCT/CN2018/101824
(87) International publication number: WO 2019/161644

(57) **Abstract**

A composite material and a preparation method thereof are provided, to resolve a prior-art problem that a silicon negative electrode material in a battery is vulnerable to crack and pulverization. The composite material includes a layered silicon core and a plurality of carbon nanotubes. The layered silicon core includes a plurality of silicon-based material layers, there is an interlayer spacing between two adjacent silicon-based material layers, each silicon-based material layer has at least one through hole, and the silicon-based material layer includes silicon or silicon oxide. Each of the plurality of carbon nanotubes passes through the through holes on at least two silicon-based material layers.

## Description

This application claims priority to Chinese Patent Application No. 201810159491.2, filed with the Chinese Patent Office on February 26, 2018 and entitled "COMPOSITE MATERIAL AND PREPARATION METHOD THEREOF", which is incorporated herein by reference in its entirety.

### TECHNICAL FIELD

This application relates to the field of material technologies, and in particular, to a composite material and a preparation method thereof.

### BACKGROUND

Graphite is usually used as a negative electrode material of a lithium-ion battery. A theoretical capacity of the graphite is 372 mAh/g, but a current actual capacity of the graphite has exceeded 360 mAh/g, which approaches the theoretical limit value. In other words, there is little space for improvement in the capacity of the graphite, and this restricts further improvement of energy density of the battery.

Silicon has a theoretical capacity of 4200 mAh/g, far greater than that of the graphite, and a silicon-based material is a potential candidate as the negative electrode material of the battery. However, in a charge/discharge process of the battery, a silicon-based negative electrode material continuously switches between a fully-lithiated state and a delithiated state. A volume of the silicon-based negative electrode material in the fully-lithiated state increases by about 300% to 400% compared with a volume of the silicon-based negative electrode material in the delithiated state. Frequent and dramatic changes in volume may cause the silicon-based negative electrode material to be vulnerable to crack and pulverization, and battery lifespan is shortened.

### SUMMARY

This application provides a composite material and a preparation method thereof, to resolve a prior-art problem that a silicon-based negative electrode material in a battery is vulnerable to crack and pulverization.

According to a first aspect, this application provides a composite material, including a layered silicon core and a plurality of carbon nanotubes. The layered silicon core includes a plurality of silicon-based material layers, and the silicon-based material layer includes silicon or silicon oxide, for example, silicon monoxide. There is an interlayer spacing between two adjacent silicon-based material layers. The interlayer spacing may be different at different locations between the two adjacent silicon-based material layers, and interlayer spacings of different two adjacent layers may also be different. Each silicon-based material layer has at least one through hole, and different through holes may have different shapes and sizes. Each of the plurality of carbon nanotubes penetrates the silicon-based material layer via the through hole on the silicon-based material layer. Some carbon nanotubes may penetrate all silicon-based material layers in the layered silicon core, and some carbon nanotubes may penetrate only some silicon-based material layers. Some through holes may be passed through by one carbon nanotube, and some through holes may be passed through by a plurality of carbon nanotubes.

There is an interlayer spacing between two adjacent silicon-based material layers in the composite material. The interlayer spacing can relieve an expansion pressure of the composite material during lithiation, and reduce a probability that the composite material is cracked or pulverized due to a relatively great change in volume. In addition, holes on the silicon-based material layer can alleviate intra-layer stress of the layered silicon core in a contraction-expansion process, and further reduce a probability that the silicon-based material layer is cracked and pulverized. In addition, a carbon nanotube array that penetrates the layered silicon core can provide a relatively strong longitudinal support for the layered silicon core, thereby enhancing strength of the composite material. In addition, the carbon nanotube array can further enhance electrical conductivity of the composite material, and improve performance of a battery. The carbon nanotube array includes a plurality of carbon nanotubes in a same orientation or similar orientations.

In some optional implementations, two adjacent silicon-based material layers are at least partially connected, to enhance structural strength of the layered silicon core and interlayer electrical conductivity of the silicon-based material layer.

In some optional implementations, each of the carbon nanotubes is connected to one or more silicon-based material layers. For example, the carbon nanotube may be connected to edges of one or more through holes passed through by the carbon nanotube, or may be connected to a silicon-based material layer that is in contact with but is not penetrated by the carbon nanotube. The foregoing structure can enhance structural strength of the layered silicon core and interlayer electrical conductivity of the silicon-based material layer.

In some optional implementations, the composite material further includes a coating layer that coats an outer surface of the layered silicon core. The coating layer coats the layered silicon core inside the coating layer. The coating layer may be a carbon coating layer, an inorganic compound coating layer, or an organic compound coating layer. The coating layer can reduce direct contact between the layered silicon core and an electrolyte, and therefore reduce battery capacity attenuation. In addition, when the coating layer is the carbon coating layer, an effective conductive interface can be further provided, and power performance of the battery is improved.

In some optional implementations, when a layered silicon core 110 is in a delithiated state, an interlayer spacing between two adjacent silicon-based material layers 111 in the layered silicon core 110 ranges from 10 nanometers (nm) to 10 micrometers (µm). For example, the interlayer spacing between the two adjacent silicon-based material layers 111 may be 10 nm, 40 nm, 120 nm, 660 nm, 1 µm, 5 µm, 8 µm, 10 µm, or the like. With one of the foregoing interlayer spacings, the layered silicon core 110 has a comparatively small change in volume when switching between the delithiated state and a lithiated state, and this reduces a probability that the composite material is cracked and pulverized.

According to a second aspect, this application provides a method for preparing a composite material, including: preparing a porous metal silicide by using a metal and a porous silicon-based material, where the silicon-based material may be silicon or a silicon oxide. The porous silicon-based material may be a finished product, or may be prepared. The pore may be located on a surface or inside of the silicon-based material, and the pore may be a through hole. A process of preparing the metal silicide by using the silicon-based material and the metal may be sintering, evaporation, sputtering, electroplating, chemical vapor deposition (chemical vapor deposition, CVD), or the like. The method for preparing a composite material further includes: leaving the porous metal silicide and a metal removal agent in reaction, to obtain a layered silicon core, where the layered silicon core includes a plurality of silicon-based material layers, there is an interlayer spacing between two adjacent silicon-based material layers, each silicon-based material layer has at least one through hole, and the silicon-based material layer includes silicon or a silicon oxide. The metal removal agent may be ethanol, propanol, butanol, isopropanol, CuCl₂, SnCl₂, HCl, or the like. The method for preparing a composite material further includes: preparing a plurality of carbon nanotubes in the layered silicon core, where each of the plurality of carbon nanotubes penetrates at least two silicon-based material layers via through holes on the at least two silicon-based material layers. Some carbon nanotubes may penetrate all silicon-based material layers in the layered silicon core, and some carbon nanotubes may penetrate only some silicon-based material layers. Some through holes may be passed through by one carbon nanotube, and some through holes may be passed through by a plurality of carbon nanotubes.

There is an interlayer spacing between two adjacent silicon-based material layers in the composite material prepared through the foregoing method. The interlayer spacing can relieve an expansion pressure of the composite material during lithiation, and reduce a probability that the composite material is cracked or pulverized due to a relatively great change in volume. In addition, holes on the silicon-based material layer can alleviate intra-layer stress of the layered silicon core in a contraction-expansion process, and further reduce a probability that the silicon-based material layer is cracked and pulverized. In addition, a carbon nanotube array that penetrates the layered silicon core can provide a relatively strong longitudinal support for the layered silicon core, thereby enhancing strength of the composite material. In addition, the carbon nanotube array can further enhance electrical conductivity of the composite material, and improve performance of a battery.

In some optional implementations, the method for preparing a composite material further includes: preparing a coating layer on an outer surface of the layered silicon core in which the plurality of carbon nanotubes are formed, where the coating layer coats the layered silicon core inside the coating layer. The coating layer may be an amorphous carbon coating layer, or may be an inorganic compound coating layer, such as a lithium titanate coating layer, or may be an organic coating layer, such as a polyaniline coating layer. The coating layer can reduce direct contact between the layered silicon core and an electrolyte, and therefore reduce battery capacity attenuation. In addition, when the coating layer is the carbon coating layer, an effective conductive interface can be further provided, and power performance of the battery is improved.

In some optional implementations, the method for preparing a plurality of carbon nanotubes includes: preparing the plurality of carbon nanotubes in the layered silicon core through a chemical vapor deposition CVD process, where each of the plurality of carbon nanotubes penetrates the at least two silicon-based material layers via the through holes on the at least two silicon-based material layers. The method for preparing carbon nanotubes has low costs and high efficiency.

In some optional implementations, the method for preparing a plurality of carbon nanotubes further includes: migrating the plurality of carbon nanotubes into the layered silicon core, where each of the plurality of carbon nanotubes penetrates the at least two silicon-based material layers via the through holes on the at least two silicon-based material layers. The method for preparing carbon nanotubes has low costs and high efficiency.

In some optional implementations, a method for preparing a porous silicon-based material includes: leaving a silicon-based particle and a colloidal sphere in self-assembly, to form a precursor, where the silicon-based particle includes a silicon particle or a silicon oxide particle, and the colloidal sphere is volatile at high temperature, for example, polystyrene (polystyrene, PS); and calcining the precursor, and removing the colloidal sphere, to form the porous silicon-based material. The method for preparing a porous silicon-based material has low costs and high efficiency.

In some optional implementations, the metal for preparing the metal silicide includes an alkali metal or an alkali earth metal.

According to a third aspect, this application provides a battery, including a positive electrode, an electrolyte, and a negative electrode. An electrode material of the positive electrode may be a lithium compound, such as lithium manganate, lithium iron phosphate, or lithium nickel cobalt manganese oxide. An electrode material of the negative electrode may be the composite material according to the first aspect or any optional manner of the first aspect. Alternatively, an electrode material of the negative electrode is prepared through the method according to the second aspect or any optional manner of the second aspect. The electrolyte may be ethylene carbonate, propylene carbonate, diethyl carbonate, dimethyl carbonate, ethyl methyl carbonate, phosphorus pentafluoride, hydrofluoric acid, or the like.

According to a fourth aspect, this application provides a method for improving a negative electrode material of a lithium ion battery. The method includes: using a layered silicon core as a body of a silicon negative electrode material. The layered silicon core includes a plurality of silicon-based material layers, there is an inter layer spacing between two adjacent silicon-based material layers, each silicon-based material layer has at least one through hole, and the silicon-based material layer includes silicon or a silicon oxide. The interlayer spacing between two adjacent layers in the layered silicon core can relieve an expansion pressure of the silicon negative electrode material in a lithiated state, because the silicon-based material layer can expand to the interlayer spacing during lithiation. This reduces a change in volume of the entire layered silicon core, and reduces a probability that a composite material is cracked and pulverized. In addition, the silicon-based material layer in the layered silicon core has holes, and the holes can alleviate intra-layer stress of the silicon-based material layer in the layered silicon core in a contraction-expansion process, and further reduce a probability that the silicon-based material layer is cracked and pulverized. The method further includes: disposing a plurality of carbon nanotubes inside the layered silicon core, where each of the plurality of carbon nanotubes penetrates at least two silicon-based material layers via through holes on the at least two silicon-based material layers. The plurality of carbon nanotubes can provide a relatively strong longitudinal support for the layered silicon core, thereby enhancing strength of the silicon negative electrode material. In addition, the plurality of carbon nanotubes can further enhance interlayer electronic conduction between the silicon-based material layers, enhance electrical conductivity of the silicon negative electrode material, and therefore improve performance of the battery.

### BRIEF DESCRIPTION OF DRAWINGS

FIG. 1a and FIG. 1b are schematic structural diagrams of a composite material according to an embodiment of this application;
FIG. 2 is a schematic diagram of a silicon-based material layer in a lithiated state and a delithiated state;
FIG. 3a and FIG. 3b are schematic diagrams of adjacent silicon-based material layers;
FIG. 4 is a schematic diagram of a coating layer of a composite material;
FIG. 5 is a schematic diagram of interlayer spacings between adjacent silicon-based material layers;
FIG. 6 is a schematic flowchart of a method for preparing a composite material according to an embodiment of this application;
FIG. 7a is a schematic diagram of a process of forming a layered silicon core;
FIG. 7b is a schematic diagram of a process of forming a through hole on a silicon-based material layer; and
FIG. 8 is a schematic structural diagram of a battery according to an embodiment of this application.

### DESCRIPTION OF EMBODIMENTS

To make the objectives, technical solutions, and advantages of this application clearer, the following further describes this application in detail with reference to the accompanying drawings.

In this application, "a plurality of' refers to two or more than two. In addition, the term "and/or" in this application describes only an association relationship for describing associated objects and represents that three relationships may exist. For example, A and/or B may indicate the following three cases: Only A exists, both A and B exist, and only B exists.

The following first describes some concepts in the embodiments of this application.

Carbon nanotubes (carbon nanotubes, CNTs): CNTs are also referred to as buckytubes, and are of a seamless nanotube structure formed through rolling of a single-layer or multi-layer graphene sheet around a same central axis. The carbon nanotube has an excellent mechanical property, relatively strong strength, and excellent electrical conductivity and thermal conductivity.

Carbon nanotube array: A carbon nanotube array includes a plurality of carbon nanotubes in a same orientation or similar orientations.

Chemical vapor deposition (chemical vapor deposition, CVD): CVD refers to a process in which other gas required for a reaction and vapors of a gaseous reactant or a liquid reactant that includes an element constituting a target substance are introduced to a reaction chamber, and react on a substrate surface to generate a thin film, a particle, or a quantum dot.

Solid electrolyte interface (solid electrolyte interface, SEI) film: A SEI film is a passivation layer that forms on a surface of an electrode material due to a reaction between the electrode material and an electrolyte on a solid-liquid interface during an initial charge/discharge process of a liquid lithium-ion battery. The passivation film can effectively prevent a solvent molecule from passing through, but a lithium ion can be freely intercalated and deintercalated through the passivation layer. The passivation layer has a feature of a solid electrolyte, and therefore, the passivation film is referred to as a solid electrolyte interface film.

Self-assembly (self-assembly): Self-assembly is a technology in which basic structural units (molecules, nanomaterials, or substances of a micron scale or a larger scale) spontaneously form an organized structure. In a process of self-assembly, the basic structural units spontaneously organize themselves or aggregate into a stable structure with a regular geometric appearance under the interaction of non-covalent bonds.

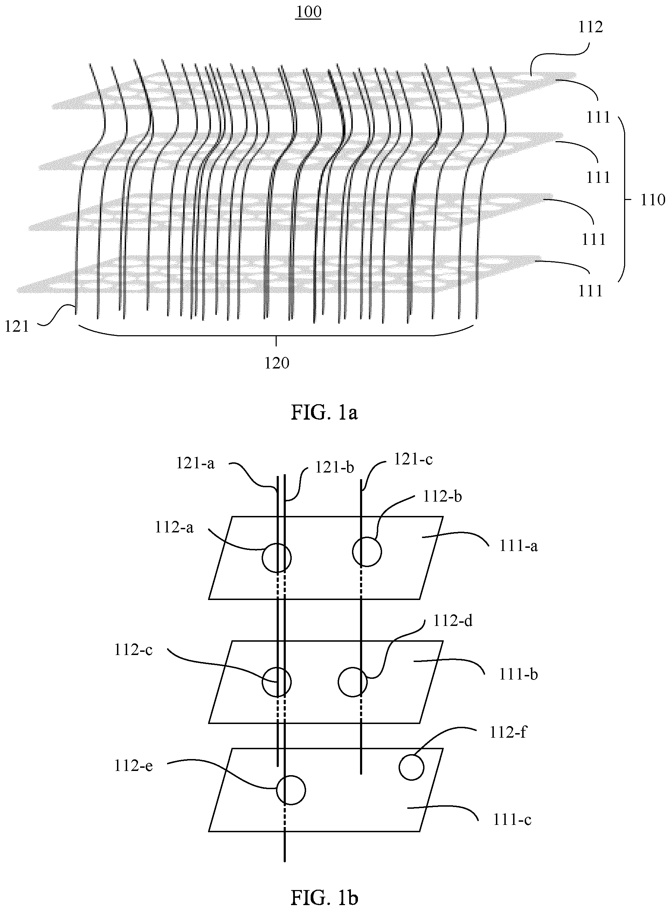

FIG. 1a shows a structure of a composite material 100 according to this application. The composite material 100 includes a layered silicon core 110 and a carbon nanotube array 120.

The layered silicon core 110 includes a plurality of silicon-based material layers 111. The silicon-based material layer 111 may be a silicon (Si) layer or a silicon oxide layer, for example, a silicon monoxide (SiO) layer. Optionally, the silicon-based material layer 111 may include but is not all silicon dioxide, to improve a lithiation capability. When the silicon-based material layer 111 is the Si layer, a thickness of the silicon-based material layer 111 may be a thickness of one or more atomic layers. When the silicon-based material layer 111 is the silicon oxide layer, a thickness of the silicon-based material layer 111 may be a thickness of one or more molecular layers. Thicknesses of different silicon-based material layers 111 may be the same or different. Each silicon-based material layer 111 has one or more through holes 112. Different through holes may have different shapes and sizes. In the accompanying drawings of this application, all through holes are in a circular shape for simplicity. There is an interlayer spacing between two adjacent silicon-based material layers 111, and interlayer spacings between different adjacent silicon-based material layers 111 may be different.

The carbon nanotube array 120 includes a plurality of carbon nanotubes 121. The carbon nanotube 121 penetrates the silicon-based material layer via a through hole on the silicon-based material layer. It should be understood that, some carbon nanotubes 121 may penetrate all silicon-based material layers 111, and some carbon nanotubes may penetrate only some silicon-based material layers 111. Some through holes may be passed through by one carbon nanotube 121, and some through holes may be passed through by a plurality of carbon nanotubes 121. For example, FIG. 1b is a partially enlarged schematic diagram of a composite material. A silicon-based material layer 111-b is adjacent to both a silicon-based material layer 111-a and a silicon-based material layer 111-c. The silicon-based material layer 111-a has a through hole 112-a and a through hole 112-b, the silicon-based material layer 111-b has a through hole 112-c and a through hole 112-d, and the silicon-based material layer 111-c has a through hole 112-e and a through hole 112-f. The through hole 112-a and the through hole 112-c are exactly aligned; the through hole 112-c and the through hole 112-e are partially aligned; a carbon nanotube 121-a passes through the through hole 112-a and the through hole 112-c; and a carbon nanotube 121-b passes through the through hole 112-a, the through hole 112-c, and the through hole 112-e. The through hole 112-b and the through hole 112-d are partially aligned; the through hole 112-d and the through hole 112-f are completely unaligned; and a carbon nanotube 121-c passes through the through hole 112-b and the through hole 112-d. In FIG. 1b, the carbon nanotube 121 is straight for simplicity. In an actual case, the carbon nanotube 121 may be curved.

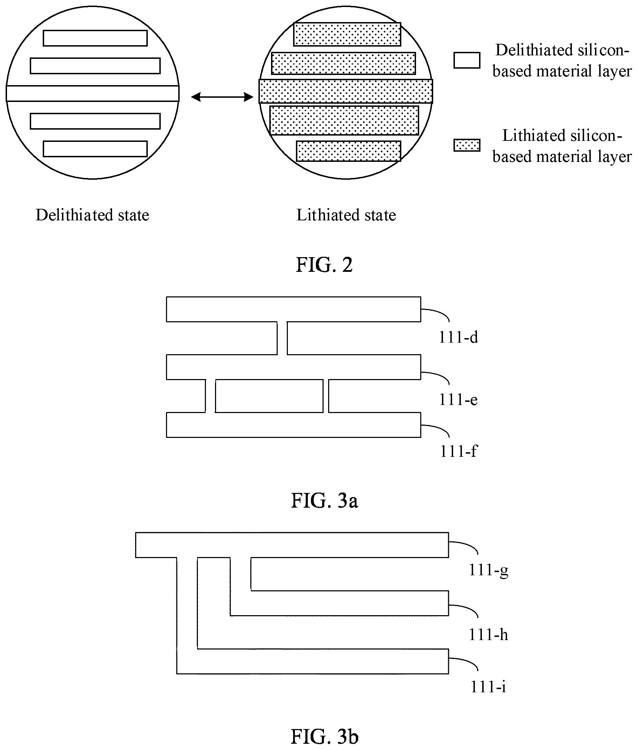

Referring to FIG. 2, when the layered silicon core 110 is in a lithiated state, lithium ions are intercalated into the silicon-based material layers 111. In this case, volumes of the silicon-based material layers 111 increase, and interlayer spacings between the silicon-based material layers 111 decrease. The decrease of the interlayer spacings in the layered silicon core 110 may reduce an outward expansion of the entire layered silicon core 110. Therefore, the layered silicon core 110 structure can reduce a change in volume of the composite material 100 switching between the lithiated state and a delithiated state, and reduce a probability that the composite material is cracked and pulverized. In addition, the silicon-based material layer 111 in the layered silicon core 110 has holes, and the holes can alleviate intra-layer stress of the silicon-based material layer 111 in the layered silicon core in a contraction-expansion process, and further reduce a probability that the silicon-based material layer 111 is cracked and pulverized. In addition, the carbon nanotube array 120 that penetrates the plurality of silicon-based material layers 111 can provide a relatively strong longitudinal support for the layered silicon core 110, thereby enhancing strength of the composite material 100. In addition, the carbon nanotube array 120 that penetrates the plurality of silicon-based material layers 111 can further enhance interlayer electronic conduction between the silicon-based material layers 111, enhance electrical conductivity of the composite material, and therefore improve performance of a battery.

In an optional design, two adjacent silicon-based material layers 111 are partially connected. As shown in FIG. 3a, a silicon-based material layer 111-e is connected to an adjacent silicon-based material layer 111-d and an adjacent silicon-based material layer 111-f. In another optional design, two adjacent silicon-based material layers 111 may not be connected to each other. As shown in FIG. 3b, adjacent silicon-based material layers 111-h and 111-i are not connected to each other, but both are connected to a silicon-based material layer 111-g. In the former design of the foregoing two optional designs, two adjacent silicon-based material layers 111 are connected to each other, and this can enhance structural strength of the layered silicon core 110 and interlayer electrical conductivity of the silicon-based material layer 111. It should be noted that, to better embody the interlayer spacing in the layered silicon core 110, in the accompanying drawings of the specification other than FIG. 3a and FIG. 3b, the silicon-based material layers 111 are separated from each other for simplicity.

In some optional designs, each carbon nanotube 121 in the carbon nanotube array 120 is connected to one or more silicon-based material layers. For example, referring to FIG. 1b, the carbon nanotube 121-b may be connected to edges of one or more through holes passed through by the carbon nanotubes 121-b, and the carbon nanotube 121-a may be connected to the silicon-based material layer 111-c that is not penetrated by the carbon nanotube 121-a. The foregoing structure can enhance structural strength of the layered silicon core 110 and interlayer electrical conductivity of the silicon-based material layer 111.

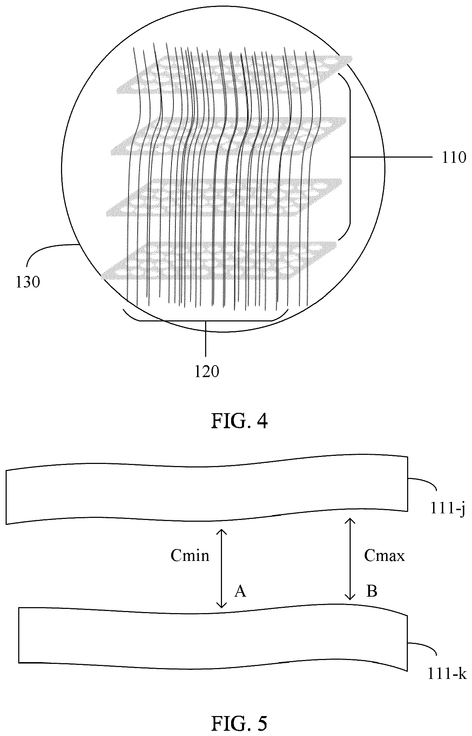

In some optional designs, referring to FIG. 4, the composite material 100 further includes a coating layer 130 that coats an outer surface of the layered silicon core 110. The coating layer 130 coats the layered silicon core 110 inside the coating layer 130. The coating layer may be an amorphous carbon coating layer, or may be an inorganic compound coating layer, such as a lithium titanate coating layer, or may be an organic coating layer, such as a polyaniline coating layer. It should be noted that in FIG. 4, a cross-section of the coating layer is in a circular shape for simplicity. During specific implementation, the cross section of the coating layer may be in another shape such as an ellipse, or may be in an irregular shape.

Direct contact between the layered silicon core and the electrolyte results in generation of new SEI films by silicon and the electrolyte. This exhausts the electrolyte and greatly reduces battery capacity. In the foregoing technical solution, the coating layer 130 is prepared on the outer surface of the layered silicon core 110. This can reduce direct contact between the layered silicon core and the electrolyte, and reduce battery capacity attenuation. In addition, when the coating layer 130 is the carbon coating layer, electrical conductivity of the composite material 100 may be further enhanced.

In some optional designs, when the layered silicon core 110 is in the delithiated state, an interlayer spacing between two adjacent silicon-based material layers 111 in the layered silicon core 110 ranges from 10 nanometers (nm) to 10 micrometers (µm). For example, the interlayer spacing between the two adjacent silicon-based material layers 111 may be 10 nm, 40 nm, 120 nm, 660 nm, 1 µm, 5 µm, 8 µm, 10 µm, or the like. With one of the foregoing interlayer spacings, the layered silicon core 110 has a comparatively small change in volume when switching between the delithiated state and the lithiated state, and this reduces a probability that the composite material is cracked and pulverized.

It should be understood that the interlayer spacing between two adjacent layers may be different at different locations. As shown in FIG. 5, an interlayer spacing between adjacent silicon-based material layers 111-j and 111-k is not a fixed value. There is a minimum interlayer spacing (Cmin) at a location A, and there is a maximum interlayer spacing (Cmax) at a location B.

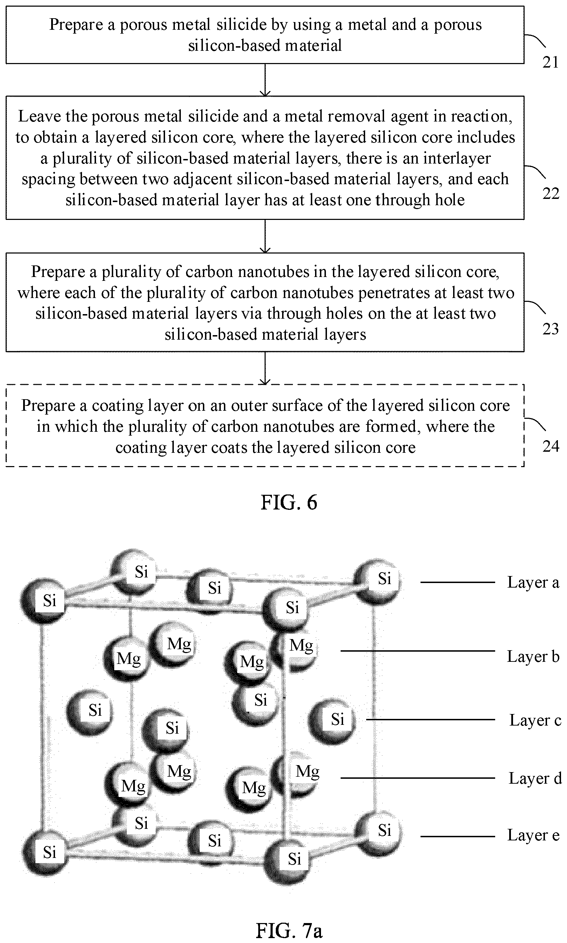

The following describes some possible preparation methods for a composite material 100. Referring to FIG. 6, the preparation method includes the following steps.

Step 21: Prepare a porous metal silicide by using a metal and a porous silicon-based material.

The silicon-based material includes silicon or silicon oxide, such as silicon monoxide, or silicon dioxide. The pore on the silicon-based material may be located on a surface or inside of the silicon-based material, and the pore may be a through hole. The porous silicon-based material may be a finished product, or may be prepared through the following process. The preparation process is as follows: First, a silicon-based particle and a colloidal sphere initiate self-assembly, to form a precursor, where the silicon-based particle includes a silicon particle or a silicon oxide particle, and the colloidal sphere is volatile at high temperature, for example, polystyrene (polystyrene, PS). Then, the precursor is calcined, and the colloidal sphere is removed. A location originally occupied by the colloidal sphere becomes a pore, and a porous silicon-based material is obtained. The process of preparing a porous silicon-based material is simple and has low costs.

The process of preparing the metal silicide by using the silicon-based material and the metal may be sintering, evaporation, sputtering, electroplating, CVD, or the like. The metal used to prepare the metal silicide may be an alkali metal or an alkali earth metal, for example, Li, Na, Ca, or Mg. In some embodiments, only one type of metal is used to prepare the metal silicide. For example, porous silicon dioxide and magnesium (Mg) are mixed and heated, to obtain porous Mg₂Si. In some other embodiments, two or more types of metals may be used to prepare the metal silicide. For example, Li₃NaSi₆ is prepared by using lithium, sodium, and silicon dioxide.

Step 22: Leave the porous metal silicide and a metal removal agent in reaction, to obtain a layered silicon core, where the layered silicon core includes a plurality of silicon-based material layers, there is an interlayer spacing between two adjacent silicon-based material layers, each silicon-based material layer has at least one through hole, and the silicon-based material layer includes silicon or a silicon oxide.

The metal removal agent is used for demetalation with the metal silicide, and the metal removal agent may be different depending on different kinds of the metal silicide. For example, when the metal silicide is a lithium silicide (LiSix), the metal removal agent is a chemical de-lithium reagent, including but is not limited to ethanol, propanol, butanol, isopropanol, or the like. When the metal silicide is calcium silicide (CaSi₂), the metal removal agent may be an oxidizing reagent or an acid solution, including but not limited to CuCl₂, SnCl₂, HCl, or the like. When the metal silicide reacts with the metal removal agent in different reaction media, silicon-based materials in different oxidation states can be obtained. When calcium silicide reacts with the metal removal agent in an alcohol reaction medium, a silicon oxide different from silicon dioxide can be obtained, expressed as SiOx. When calcium silicate reacts with the metal removal agent in a molten salt reaction medium, pure Si is obtained.

The following uses MgSi as an example to describe a mechanism for forming a layered silicon core after a metal is removed from MgSi. FIG. 7a shows a unit cell structure of MgSi, where Si particles form a face-centered cubic structure, Mg particles form a primitive cubic structure, and an entire unit cell of MgSi may be divided into five layers: a layer a to a layer e. After MgSi reacts with the metal removal agent, Mg particles at the layer b and the layer d are removed, and a spacing between the layer a and the layer c and a spacing between the layer c and the layer e are relatively large. In other words, interlayer spacings are formed. It should be understood that the foregoing mechanism is a theoretical mechanism for forming a layered silicon core. A unit cell structure of the prepared metal silicide may have various distortions (such as a line defect, a surface defect, and a body defect). Therefore, thicknesses of different silicon-based material layers in the layered silicon core formed after metal is removed from the metal silicide may be different, and interlayer spacings between different adjacent silicon-based material layers may also be different.

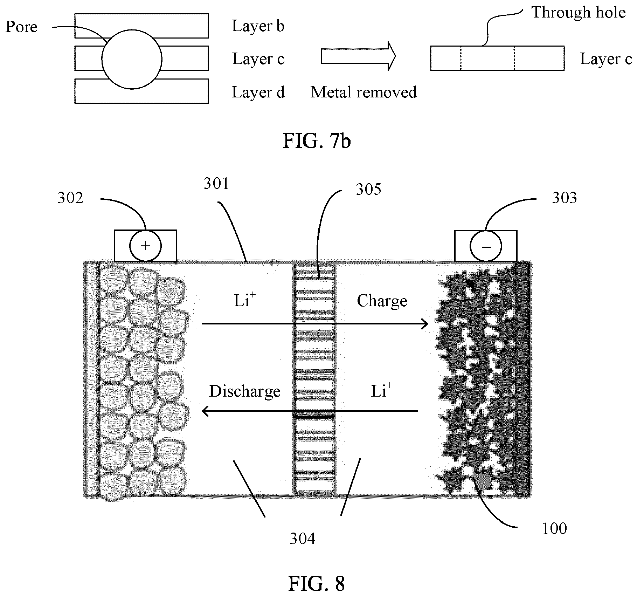

The layer c shown in FIG. 7a is used as an example to describe a process of forming a through hole on the silicon-based material layer. As shown in the left side of FIG. 7b, there is a pore inside the layers b to d of the metal silicide before the metal is removed. After the metal is removed, a pore on the layer c becomes a through hole.

Step 23: Prepare a plurality of carbon nanotubes in the layered silicon core, where each of the plurality of carbon nanotubes penetrates at least two silicon-based material layers via through holes on the at least two silicon-based material layers.

The plurality of carbon nanotubes form a carbon nanotube array, and a manner of preparing the carbon nanotube array may be as follows:

First, a plurality of carbon nanotubes that pass through the through holes on the silicon-based material layers in the layered silicon core are prepared in situ in the layered silicon core. For example, the carbon nanotube array may be prepared in the through holes in the layered silicon core through the CVD process. Specifically, the layered silicon core prepared in step 22 is heated, and after a temperature rises to a specified temperature, a gaseous carbon source is introduced for a period of time. Subsequently, the gaseous carbon source is not introduced, and argon Ar gas is introduced instead for cooling. Then the carbon nanotube array that passes through the through holes on the silicon-based material layers in the layered silicon core may be formed. The gaseous carbon source may be a gaseous hydrocarbon substance including a carbon atom, including but not limited to methane, ethane, propane, ethylene, propylene, acetylene, or the like.

Second, the prepared carbon nanotubes are migrated to the through holes on the silicon-based material layers in the layered silicon core, to form the carbon nanotube array. For example, carbon nanotubes that grow on another substrate are immersed in a solution, for example, alcohol or isopropanolamine (Isopropanolamine, IPA), and the substrate on which the carbon nanotubes grow is corroded. Then in the liquid phase, the carbon nanotubes are migrated to the through holes on the silicon-based material layers in the layered silicon core.

When the composite material prepared through the foregoing process is in a lithiated state, lithium ions are intercalated into the silicon-based material layers. In this case, volumes of the silicon-based material layers increase, and interlayer spacings between the silicon-based material layers decrease. The decrease of the interlayer spacings in the layered silicon core may reduce an outward expansion of the entire layered silicon core. Therefore, the layered silicon core structure can reduce a change in volume of the composite material switching between the lithiated state and a delithiated state, and reduce a probability that the composite material is cracked and pulverized. In addition, the silicon-based material layer in the layered silicon core has holes, and the holes can alleviate intra-layer stress of the silicon-based material layer in the layered silicon core in a contraction-expansion process, and further reduce a probability that the silicon-based material layer is cracked and pulverized. In addition, the carbon nanotube array that penetrates the plurality of silicon-based material layers can provide a relatively strong longitudinal support for the layered silicon core, thereby enhancing strength of the composite material. In addition, the carbon nanotube array that penetrates the plurality of silicon-based material layers can further enhance interlayer electronic conduction between the silicon-based material layers, enhance electrical conductivity of a negative electrode of a battery, and therefore improve performance of the battery.

In some optional designs, the following step is further performed after step 23:
Step 24: Prepare a coating layer on an outer surface of the layered silicon core in which the plurality of carbon nanotubes are formed, where the coating layer coats the layered silicon core inside the coating layer. The coating layer may be an amorphous carbon coating layer, or may be an inorganic compound coating layer, such as a lithium titanate coating layer, or may be an organic coating layer, such as a polyaniline coating layer.

For example, the coating layer is the carbon coating layer. In this embodiment of this application, the carbon coating layer may be prepared in a plurality of manners, including but not limited to evaporation, sputtering, electroplating, CVD, or the like. For example, the layered silicon-carbon nanotube composite material formed in step 23 is mixed with a carbon source, to obtain a precursor of carbon. The precursor of carbon undergoes pyrolysis at a high temperature, and forms a carbon coating layer on the outer surface of the layered silicon-carbon nanotube composite material. The carbon source is the gaseous carbon source, a liquid carbon source, or a solid carbon source. The gaseous carbon source includes but is not limited to methane, ethane, ethylene, acetylene, propylene, carbon monoxide, or the like. The liquid carbon source includes but is not limited to methanol, ethanol, hexane, cyclohexane, benzene, toluene, xylene, or the like. The solid carbon source includes but is not limited to polyethylene, polypropylene, polyvinyl chloride, polyvinylidene difluoride, polyacrylonitrile, polystyrene, epoxy, phenol formaldehyde resin, glucose, fructose, sucrose, maltose, coal tar pitch, petroleum asphalt, or the like.

In the foregoing technical solution, the coating layer is prepared on the outer surface of the layered silicon core. The coating layer can solidify the layered silicon core, and avoid direct contact between the layered silicon core and an electrolyte. This reduces a side reaction, prevents silicon pulverization in a long-term cycle process, and further improves cycle performance. In addition, when the coating layer is the carbon coating layer, electrical conductivity of the composite material can be improved, and therefore performance of the battery can be improved.

The following describes an application example of preparing the foregoing composite material. This embodiment provides a specific method for preparing a porous layered silicon/carbon nanotube CNTs composite material, including the following steps:
(1) According to a specific stoichiometric ratio, a 500-nanometer (nm) polystyrene (PS) colloidal sphere and 7-nm silicon dioxide particles are dispersed in a growth glassware filled with deionized water, and after ultrasonic dispersion is performed, the growth glassware is placed in a 60°C constant-temperature water bath. Pressure inside the glassware is controlled. A self-assembly process is facilitated under irradiation of the infrared lamp, and lasts for 15 to 30 minutes, and then a polystyrene PS/silicon dioxide SiO2 precursor is generated.
(2) The polystyrene PS/silicon dioxide SiO2 precursor is calcined for 2 hours at 450°C in an air atmosphere, and the polystyrene PS sphere is removed, to obtain porous silicon dioxide SiO2.
(3) The porous silicon dioxide SiO2 and metal magnesium Mg at a stoichiometric ratio of 1:1.05 are fully mixed through a ball milling process. Then the compound of SiO2 and Mg is transferred to a tube furnace, is heated up to 650°C at a heating rate of 5°C/min, and reacts for 4 hours in a hydrogen-argon mixture atmosphere (5:95). After the compound is cooled to a room temperature, a product is processed for 6 hours by using 2mol/L hydrochloric acid HCl and is processed for 1 hour by using 10% hydrofluoric acid HF, to remove impurities magnesium oxide MgO and silicon dioxide SiO2 and obtain porous layered Si. The porous layered Si is a possible form of a layered silicon core having a through hole.
(4) The porous layered silicon Si is dispersed on a quartz substrate, and is transferred to a reaction furnace. Protective gas (for example, a hydrogen-argon mixture) is introduced, and the temperature is increased to 700°C at a rate of 20°C/min, and maintains for 20 minutes. Subsequently, the protective gas is not introduced, and carbon source gas acetylene and nitrogen at a volume ratio of 1:1 are introduced instead at a rate of 200-300 mL/min. After a 30-60 min reaction, the temperature is cooled to the room temperature in a protective gas atmosphere, and a composite material in which carbon nanotubes CNTs penetrate the porous layered silicon Si is obtained.

The foregoing preparation process for a composite material is simple, and has comparatively low costs. In addition, when the porous layered silicon Si-carbon nanotube CNTs composite material prepared is used as a negative electrode of a battery, the composite material has comparatively strong strength and favorable electrical conductivity. Further, the composite material has a comparatively small change in volume in a charge/discharge process of the battery, and has a stable structure and a comparatively long lifespan.

FIG. 8 shows a battery according to an embodiment of this application. The battery includes a housing 301, a positive electrode 302, a negative electrode 303, and an electrolyte 304. The positive electrode 302, the negative electrode 303, and the electrolyte 304 are accommodated inside the housing 301. An electrode material of the positive electrode 302 may be a lithium compound, such as lithium manganate, lithium iron phosphate, or lithium nickel cobalt manganese oxide. The negative electrode 303 may be prepared according to the method for preparing the composite material 100, or an electrode material of the negative electrode 303 may be prepared through the foregoing process in step 21 to step 23 or the process in step 21 to step 24. During charge of the battery, the positive electrode 302 releases cations, for example, lithium ions. The lithium ions released by the positive electrode move to the negative electrode 303 through the electrolyte, and are intercalated into a negative electrode material. On the contrary, during discharge of the battery, the negative electrode 303 releases cations. The cations move to the positive electrode 302 through the electrolyte and are intercalated into a positive electrode material. The electrolyte 304 may be ethylene carbonate, propylene carbonate, diethyl carbonate, dimethyl carbonate, ethyl methyl carbonate, phosphorus pentafluoride, hydrofluoric acid, or the like. It should be understood that the battery may further include a structure such as a separator diaphragm 305 and an extraction electrode.

When the composite material 100 prepared for the negative electrode 303 is in a lithiated state, lithium ions are intercalated into silicon-based material layers. In this case, volumes of the silicon-based material layers increase, and interlayer spacings between the silicon-based material layers decrease. The decrease of the interlayer spacings in a layered silicon core may reduce an outward expansion of the entire layered silicon core. Therefore, the layered silicon core structure can reduce a change in volume of the composite material switching between the lithiated state and a delithiated state, and reduce a probability that the composite material is cracked and pulverized. In addition, the silicon-based material layer in the layered silicon core has holes, and the holes can alleviate intra-layer stress of the silicon-based material layer in the layered silicon core in a contraction-expansion process, and further reduce a probability that the silicon-based material layer is cracked and pulverized. In addition, a carbon nanotube array that penetrates a plurality of silicon-based material layers can provide a relatively strong longitudinal support for the layered silicon core, thereby enhancing strength of the composite material. In addition, the carbon nanotube array that penetrates the plurality of silicon-based material layers can further enhance interlayer electronic conduction between the silicon-based material layers, enhance electrical conductivity of the negative electrode of the battery, and therefore improve performance of the battery.

An embodiment of this application provides a method for improving a silicon negative electrode material of a lithium ion battery, to resolve a problem that the silicon negative electrode material is vulnerable to crack and pulverization. The method includes: using a layered silicon core as a body of the silicon negative electrode material. The layered silicon core includes a plurality of silicon-based material layers, there is an interlayer spacing between two adjacent silicon-based material layers, each silicon-based material layer has at least one through hole, and the silicon-based material layer includes silicon or silicon oxide. The interlayer spacing between two adjacent layers in the layered silicon core can relieve an expansion pressure of the silicon negative electrode material in a lithiated state, because the silicon-based material layer can expand to the interlayer spacing during lithiation. This reduces a change in volume of the entire layered silicon core, and reduces a probability that a composite material is cracked and pulverized. In addition, the silicon-based material layer in the layered silicon core has holes, and the holes can alleviate intra-layer stress of the silicon-based material layer in the layered silicon core in a contraction-expansion process, and further reduce a probability that the silicon-based material layer is cracked and pulverized. Further, the method further includes: disposing a plurality of carbon nanotubes inside the layered silicon core, where each of the plurality of carbon nanotubes passes through the through holes on at least two silicon-based material layers. The plurality of carbon nanotubes can provide a relatively strong longitudinal support for the layered silicon core, thereby enhancing strength of the silicon negative electrode material. In addition, the plurality of carbon nanotubes can further enhance interlayer electronic conduction between the silicon-based material layers, enhance electrical conductivity of the silicon negative electrode material, and therefore improve performance of the battery.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A composite material, comprising:
a layered silicon core, wherein the layered silicon core comprises a plurality of silicon-based material layers, there is an interlayer spacing between two adjacent silicon-based material layers, each silicon-based material layer has at least one through hole, and the silicon-based material layer comprises silicon or a silicon oxide; and
a plurality of carbon nanotubes, wherein each of the plurality of carbon nanotubes penetrates at least two silicon-based material layers via through holes on the at least two silicon-based material layers.

2. The composite material according to claim 1, wherein the two adjacent silicon-based material layers are at least partially connected.

3. The composite material according to claim 1, wherein each of the carbon nanotubes is connected to at least one silicon-based material layer.

4. The composite material according to any one of claims 1 to 3, further comprising:
a coating layer, configured to coat the layered silicon core inside the coating layer.

5. The composite material according to any one of claims 1 to 4, wherein the interlayer spacing between the two adjacent silicon-based material layers ranges from 10 nm to 10 µm.

6. A method for preparing a composite material, comprising:
preparing a porous metal silicide by using a metal and a porous silicon-based material, wherein the silicon-based material comprises silicon or a silicon oxide;
leaving the porous metal silicide and a metal removal agent in reaction, to obtain a layered silicon core, wherein the layered silicon core comprises a plurality of silicon-based material layers, there is an interlayer spacing between two adjacent silicon-based material layers, each silicon-based material layer has at least one through hole, and the silicon-based material layer comprises silicon or a silicon oxide; and
preparing a plurality of carbon nanotubes in the layered silicon core, wherein each of the plurality of carbon nanotubes penetrates at least two silicon-based material layers via through holes on the at least two silicon-based material layers.

7. The method according to claim 6, further comprising:
preparing a coating layer on an outer surface of the layered silicon core in which the plurality of carbon nanotubes are formed, wherein the coating layer coats the layered silicon core inside the coating layer.

8. The method according to claim 6 or 7, wherein the preparing a plurality of carbon nanotubes in the layered silicon core comprises:
preparing the plurality of carbon nanotubes in the layered silicon core through a chemical vapor deposition CVD process, wherein each of the plurality of carbon nanotubes penetrates the at least two silicon-based material layers via the through holes on the at least two silicon-based material layers; or
migrating the plurality of carbon nanotubes into the layered silicon core, wherein each of the plurality of carbon nanotubes penetrates the at least two silicon-based material layers via the through holes on the at least two silicon-based material layers.

9. The method according to any one of claims 6 to 8, wherein before the preparing a metal silicide by using a metal and a porous silicon-based material, the method further comprises:
leaving a silicon-based particle and a colloidal sphere in self-assembly, to form a precursor, wherein the silicon-based particle comprises a silicon particle or a silicon oxide particle; and
calcining the precursor, and removing the colloidal sphere, to form the porous silicon-based material.

10. The method according to any one of claims 6 to 9, wherein the metal comprises an alkali metal or an alkali earth metal.

11. A battery, comprising: a positive electrode, an electrolyte, and a negative electrode, wherein an electrode material of the negative electrode is the composite material according to any one of claims 1 to 5, or an electrode material of the negative electrode is prepared according to the method according to any one of claims 6 to 10.
